# NEUE EUROPÄISCHE PATENTSCHRIFT

(11) **EP 0 484 353 B2**
(45) Veröffentlichungstag und Bekanntmachung des Hinweises auf die Entscheidung über den Einspruch: **29.11.2000**
(45) Hinweis auf die Patenterteilung: 29.12.1993
(21) Anmeldenummer: 90910564.5
(22) Anmeldetag: 23.07.1990
(51) Int. Cl.: G06K 19/077

(54) **TRÄGERELEMENT MIT WENIGSTENS EINEM INTEGRIERTEN SCHALTKREIS, INSBESONDERE ZUM EINBAU IN CHIP-KARTEN**
SUBSTRATE ELEMENT WITH AT LEAST ONE INTEGRATED CIRCUIT, IN PARTICULAR A SUBSTRATE ELEMENT FOR INCLUSION IN CHIP CARDS
ELEMENT-SUPPORT PRESENTANT AU MOINS UN CIRCUIT INTEGRE, DESTINE NOTAMMENT A ETRE MONTE DANS DES CARTES A PUCES

(30) Priorität: 24.07.1989 DE 3924439
(43) Veröffentlichungstag der Anmeldung: 13.05.1992
(73) Patentinhaber: SCHNEIDER, Edgar, 85386 Eching (DE)
(72) Erfinder: SCHNEIDER, Edgar, 85386 Eching (DE)
(74) Vertreter: Winter, Brandl, Fürniss, Hübner, Röss, Kaiser, Polte Partnerschaft
(86) Internationale Anmeldenummer: DE9000559
(87) Internationale Veröffentlichungsnummer: WO9101533

(56) Entgegenhaltungen:
- EP-A- 116 148
- EP-A- 0 201 952
- FR-A- 2 588 695
- JP-A- 61 145 696
- US-A- 4 727 246
- PATENT ABSTRACTS OF JAPAN, vol. 10, no. 344 (P-518)(2400), 20 November 1986 & JP-A-61145696
- PATENT ABSTRACTS OF JAPAN, vo. 11, no. 97 (P-560)(2544) 26 March 1987 & JP-A-61248184
- PATENT ABSTRACTS OF JAPAN, vol. 8, no. 59 (E-232)(1496), 17 March 1984 & JP-A-58210646
- "Einführung in die DIN-Normen", 8. Auflage, Teubner Verlag, S. 444, Tabelle 444.1

## Beschreibung

Die vorliegende Erfindung betrifft ein Trägerelement mit wenigstens einem integriertem Schaltkreis bzw. Halbleiter-Chip, insbesondere für den Einbau in sogenannte Chip-Karten.

Chip-Karten finden immer breitere Verwendung als Identifikations-, Kredit- oder Buchungskarten und dergleichen. Um die Herstellung dieser Karten rationell und kostengünstig zu gestalten, wird als Trägerelement vorzugsweise ein Halbfabrikat verwendet, bei dem auf einer mit Leiterbahnen versehenen flexiblen Trägerfolie ein oder mehrere integrierte Schaltkreise in Form von Halbleiter-Kristallen montiert sind. Die Kontaktierung der integrierten Schaltkreise bzw. Halbleiter-Chips mit entsprechenden Anschlußpunkten auf der flexiblen Trägerfolie geschieht üblicherweise entweder mittels Bond-Verfahren (z.B. DE-OS 32 35 650) oder mittels Direktkontaktierungs-Verfahren (z.B. DE-AS 29 20 012). Bei der Kartenherstellung werden diese Trägerelemente in passend geformte Ausparungen des Kartenmaterials eingesetzt. Beim Verpressen von Chipkartenlaminaten und Trägerelementen treten je nach verwendetem Verfahren Drücke bis zu 160 bar auf. Dabei werden die empfindlichen integrierten Schaltkreise bzw. Halbleiter-Chips häüfig beschädigt. Auch die beim Gebrauch von Chip-Karten auftretenden Verbiegungen und daraus resultierende Biegekräfte können zu einer Beschädigung der Halbleiter-Chips führen. Um derartige Beschädigungen zu vermeiden bzw. zu reduzieren, ist es beispielsweise aus der DE-OS 36 39 630 bekannt, den bereits mit dem Trägerelement verbundenen Halbleiter-Chip durch eine Schutzfolie aus einem Material mit hohem elastischen Deformierungsvermögen abzudecken.

Durch die Verbiegungen beim Kartengebrauch kommt es auch immer wieder vor, daß an der Nahtstelle zwischen Halbleiter-Chip und Kartenmaterial Risse auftreten und unter extremen Bedingungen der gesamte Halbleiter-Kristall aus der Karte herausbricht. Um dies zu vermeiden ist es beispielsweise aus der EP-A 0 211 360 bekannt zwischen Halbleiter-Chip und Kartenmaterial eine dünne verstärkende Schicht, beispielsweise aus einem dünnen Netzgeflecht, vorzusehen.

Wenn die Halbleiter-Kristalle bzw. Halbleiter-Chips durch Banden mit den entsprechenden Anschlußpunkten auf der flexiblen Trägerfolie verbunden werden, werden die Band-Drähte und der Halbleiter-Chip üblicherweise mit einer Guß- bzw. Abdeckmasse versehen. Diese Guß- oder Abdeckmasse schützt natürlich nicht nur die Band-Drähte sondern auch den Halbleiter-Chip. Um diese Gußmasse im flüssigen bzw. halbflüssigen Zustand gezielt aufbringen zu können, ist es beispielsweise aus der DE-OS 32 35 650 bzw. der EP-A-0 107 161 bekannt, das Trägerelement mit einem dem Halbleiter-Chip samt Band-Drähten umgebenden ringförmigen Begrenzungsrahmen zu versehen. Dieser Begrenzungsring für die Abdeckmasse besteht üblicherweise aus Glasepoxy oder PVC, d. h. dem gleichen Material aus dem auch der Kartenkörper besteht. Es besteht daher die Gefahr, daß beim Verpressen der Trägerelemente mit den Chipkartenlaminat Beschädigungen des Halbleiter-Kristalls auftreten. Die Stabilität dieser Anordnung wird auch dadurch beeinträchtigt, daß der Halbleiter-Kristall in einer Ausnehmung in der flexiblen Trägerfolie angeordnet ist.

Aus der DE-OS 29 42 422 ist es bekannt, den Begrenzungsrahmen für die Verguß- bzw. Abdeckmasse gleichzeitig als Verstärkungsrahmen für das Trägerelement auszubilden. Dieser Verstärkungsrahmen ist am Rande der Trägerplatte bzw. des Trägerelements angeordnet und dient dazu, die Trägerplatte als Ganzes genügend zu versteifen. D. h. die Trägerplatte wird durch den Versteifungsring nur soweit versteift, daß sie dennoch die "erforderliche Biegsamkeit" aufweist. Erforderliche Biegsamkeit heißt in diesem Zusammenhang, daß die durch die ISO/DIN-Norm für die Chip-Karten geforderten Belastungen, insbesondere Biegebelastungen, nicht zu einer Zerstörung oder Funktionsbeeinträchtigung der Chip-Karte führen. Da die aus diesem Stand der Technik bekannten Versteifungsrahmen am Rande des Trägerelements bzw. der Trägerplatte angeordnet sind, ist es unvermeidlich, daß bei derartigen Biegungen die empfindlichen Halbleiterkristalle mechanisch beansprucht werden.

Schließlich ist aus der EP-A-0 231 937, von der der Anspruch 1 im Oberbegriff ausgeht, ein Trägerelement aus einem flexiblen Trägersubstrat bekannt, bei dem der Halbleiter-Kristall und die den Halbleiter-Kristall mit den Leiterbahnen auf dem flexiblen Trägersubstrat verbindenden Bonddrähte durch einen Versteifungsring aus rostfreiem Stahl umschlossen sind. Die Stabilität dieser Anordnung wird jedoch dadurch beeinträchtigt, daß der Halbleiter-Kristall in einer Ausnehmung in der flexiblen Trägerfolie angeordnet ist.

Aufgabe der vorliegenden Erfindung ist es, ein Trägerelement für integrierte Schaltkreise sowie ein Verfahren zu dessen Herstellung zu schaffen, bei dem die empfindlichen Bauteile sehr gut gegen mechanische Belastungen geschützt sind und eine rationelle und kostengünstige Herstellung möglich ist. Weiter ist es Aufgabe der vorliegenden Erfindung eine mit einem derartigen Trägerelement versehene Chip-Karte zu schaffen.

Die Lösung dieser Aufgabe erfolgt durch die Merkmale der Ansprüche 1 bzw. 12 bzw. 15.

Dadurch, daß der Versteifungsring eine wesentlich höhere bzw. größere Biegesteifigkeit aufweist als das flexible Trägersubstrat, d.h. der Versteifungsring im Vergleich zum Trägersubstrat völlig steif ist, können Biege- und Torsionsbeanspruchungen des Trägersubstrats nicht zur Beschädigung des von dem Versteifungsring unschlossenen Halbleiterkristalls führen. Der nur einen Teil der Fläche des Trägerelements einnehmende Verstärkungsring wirkt in Verbund mit dem flexiblen Trägersubstrat bei sämtlichen Biege- und Torsionsbeanspruchungen des Trägersubstrats als verwindungssteife Zelle und schützt dadurch den Halbleiter-Kristall vor mechanischen Beanspruchungen. Grundsätzlich sollte der Verstärkungsring den Halbleiterkristall möglichst eng umschließen, um den starren bzw. steifen Bereich möglichst klein zu halten. Der minimal notwendige Abstand zwischen dem Halbleiterkristall bzw. zwischen den Halbleiterkristallen und dem Innenrand des Verstärkungsringes wird durch den für die elektrische Verbindung des Halbleiterkristalls benötigten Raum bestimmt.

Die Biegesteifigkeit eines Körpers wird im wesentlichen durch seine geometrische Form und das Material bzw. genauer durch den Elastizitätsmodul des Materials bestimmt. Die ideale Form für den Verstärkungsring ist kreisringförmig, da dann die angreifenden Kräfte optimal von dem Verstärkungsring aufgenommen werden. Um in jedem Falle eine genügend hohe Biegesteifigkeit des Versteifungsringes zu gewährleisten, wird bei einer bevorzugten Ausführungsform Material mit einem Elastizitätsmodul von über 500 N/mm² verwendet.

Eine genügend hohe Biegesteifigkeit kann durch die Verwendung von geeigneten Metallen bzw. Metall-Legierungen gewährleistet werden. Darüberhinaus weisen Metalle noch den Vorteil auf, daß sie gegenüber den bei der Kartenherstellung auftretenden Temperaturen und Drücken (ca. 160 bar, ca. 180°C) unempfindlich sind. Insbesondere behalten Metalle bei den fraglichen Drücken und Temperaturen ihre Formstabilität, so daß der Halbleiterkristall während der Chip-Karten-Herstellung, d. h. während dem Verpressen der verschiedenen Laminatschichten, sehr gut geschützt ist.

Darüberhinaus ist Metall fertigungstechnisch leicht zu handhaben. Als bevorzugte Materialen werden für den Ring die Legierungen CuSn6, 195 HV (HV = Härte nach Vikers) oder CrNi 17/7, 220 HV verwendet.

Da der Versteifungsring gemäß der vorliegenden Erfindung natürlich nach wie vor auch die Funktion eines Begrenzungsrahmens für die Abdeckmasse erfüllt sind damit keinerlei fertigungstechnische Nachteile bzw. Mehraufwand verbunden. Wird der Versteifungsring zusätzlich mit Marken für optische Erkennungssysteme, z.B. von Handhabungsautomaten und Bondmaschinen, versehen, wird zum einen die vollautomatische Positionierung des Versteifungsringes auf der flexiblen Trägerfolie erleichtert bzw. ermöglicht und zum anderen dienen diese Marken bzw. Markierungen auch der Positionierung von vollautomatischen Bond-Maschinen bzw. Bond-Automaten. Diese Marken für optische Erkennungssysteme können beispielsweise in Form von in das Innere des Ringes vorspringende Zapfen ausgeführt sein.

Das erfindungsgemäße Trägerelement ist besonders zum Einbau in sogenannte Chip-Karten geeignet. Das dünne Trägersubstrat läßt sich sehr gut mit dem den Kartenlaminaten verpressen, so daß ein unbeabsichtigtes Herauslösen des Halbleiterkristalls während des Gebrauchs der Karte nahezu ausgeschlossen ist. Das Trägerelement ist zumindest im Randbereich nach Art eines Sandwich mit den Kartenlaminaten verbunden. Wird die Biegesteifigkeit des Verstärkungsringes so gewählt, daß sich bei Verbiegung der Chip-Karte - in Rahmen des üblichen Gebrauchs bzw. im Rahmen der ISO-Norm 7816 - der Verstärkungsring nicht verbiegt, so wirkt das oder die in die Chip-Karte integrierten Trägerelemente weiterhin wie eine verwindungssteife Zelle und schützen den Halbleiterkristall zuverlässig. Bei der Chip-Karten-Herstellung als auch beim Kartengebrauch auftretende Druck- und Scherkräfte werden im wesentlichen von dem Versteifungsring aufgenommen und somit vom Halbleiter-Chip ferngehalten.

Bei dem erfindungsgemäßen Herstellungsverfahren nach Anspruch 15 wird das Material für den Versteifungsring in Form eines ersten Bandes bzw. Flachbandes bereitgestellt. Dieses aufgerollte Flachband wird abgewickelt und mit einer Klebeschicht versehen, so daß ein Kombiband entsteht. Die Klebeschicht kann als trägerloses Klebeband in Standardform durch Aufwalzen auf dem Kombiband erzeugt werden. Alternativ hierzu kann die Klebeschicht durch unmittelbares Aufsprühen auf das erste Band erzeugt werden. Das mit Klebeschicht versehene Kombiband wird automatisch einem Stanzwerkzeug zugeführt, durch das der Versteifungsring in der gewünschten Form aus dem Metall ausgestanzt wird, jedoch so daß er in dem Band verbleibt. Das Kombiband mit dem ausgestanzten Versteifungsring wird mittels eines Handhabungsautomaten über das ebenfalls in Form eines Endlosbandes - zweites Band - automatisch zugeführte flexible Trägersubstrat positioniert und der Versteifungsring wird mit dem flexiblen Trägersubstrat verpreßt bzw. verklebt. In einem weiteren in der Zeichnung nicht näher dargestellten Verfahrensschritt wird das zweite Band mit wenigstens einem integrierten Schaltkreis bestückt, der über die Anschlußpunkte elektrisch angeschlossen wird. Anschließend wird in einem ebenfalls nicht näher dargestellten Verfahrensschritt das Innere des Versteifungsrings mit einer Abdeckmaske ausgefüllt, so daß der Halbleiter-Kristall von der Abdeckmaske schützend umgeben ist. Die so entstehenden Trägerelemente liegen nach wie vor in Form eines Bandes vor und können somit ohne weiteres automatisch weiterverarbeitet werden.

Die einzelnen Verfahrensschritte des erfindungsgemäßen Verfahrens sind im Sekundentakt ausführbar und erlauben somit eine kostengünstige Fertigung bei großen Stückzahlen.

Weitere Einzelheiten, Aspekte und Vorteile der vorliegenden Erfindung ergeben sich aus der nachfolgenden Beschreibung unter Bezugnahme auf die Zeichnungen.

Es zeigt:
- Fig. 1: Eine Schnittansicht einer bevorzugten Ausführungsform des Trägerelements mit IC;
- Fig. 2: eine Aufsicht auf die Ausführungsform nach Fig. 1;
- Fig. 3: eine schematische Darstellung einer ersten Variante eines Herstellungsverfahrens für die Trägerelemente nach Fig. 1;
- Fig. 4: eine zweite Variante eines Herstellungsverfahrens für die Trägerelemente nach Fig. 1;
- Fig. 5: einen Schnitt durch eine erste Ausführungsform einer Chip-Karte mit dem Trägerelement nach Fig. 1; und
- Fig. 6: einen Schnitt durch eine weitere Ausführungsform einer Chip-Karte mit dem erfindungsgemäßen Trägerelement.

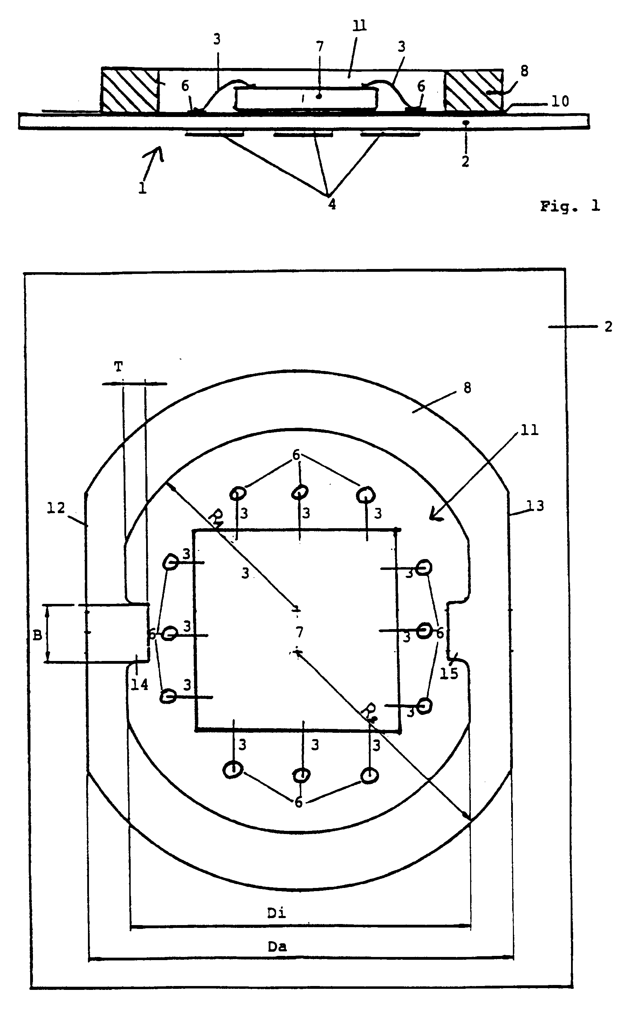

Das erfindungsgemäße Trägerelement 1 weist ein flexibles Trägersubstrat in Form einer flexiblen Trägerfolie 2 auf, auf der ein- oder beidseitig nicht dargestellte Leiterbahnen vorgesehen sind. Das Trägersubstrat 2 kann aus Polyimid, faserverstärktem Epoxy (EPG) oder Polyester bestehen. Die Leiterbahnen stellen elektrische Verbindungen zwischen Kontaktflächen 4 und Anschlußpunkten 6 her. Über die Anschlußpunkte 6 wird mittels aufgebondeten Golddrähten 3 der elektrische Kontakt zu einem integrierten Schaltkreis bzw. Halbleiter-Chip 7 hergestellt. Über die Kontaktflächen 4 wird später beim Gebrauch der fertiggestellten Chip-Karte der Kontakt zu dem Halbleiter-Chip 7 hergestellt. In dem Trägerelement 1 nach Fig. 1 liegen die Kontaktflächen 4 auf der einen Seite der flexiblen Trägerfolie 2 und die Anschlußpunkte 6 auf der anderen Seite der flexiblen Trägerfolie. Auf der Seite mit den Anschlußpunkten 6 ist auch der Halbleiter-Chip bzw. -Kristall 7 auf der Trägerfolie 2 angeordnet. Auf dieser Seite der flexiblen Trägerfolie ist auch ein den Halbleiter-Chip bzw. Halbleiterkristall 7 umschließender Versteifungsring 8 befestigt. Der Versteifungsring 8 überdeckt lediglich einen Teil der Fläche des Trägersubstrats 2. Der Versteifungsring 8 besteht aus der Metall-Legierung CuSn6 mit einer Härte von 195 HV. Die wesentlichen mechanischen Eigenschaften dieses Materials sind der nachfolgenden Tabelle zu entnehmen.

| CuSn6 | hart | federhart | doppelfederhart |
|---|---|---|---|
| Zugfestigkeit Rₘ in N/mm² | 480-580 | 550-650 | min. 630 |
| 0,2 %-Dehngrenze Rₚ 0,2 in N/mm² | min. 450 | min. 510 | min. 600 |

| Bruchdehnung | | | |
|---|---|---|---|
| A₅ % min. | 20 | 10 | 6 |
| A₁₀ % min. | 15 | 8 | - |
| Vickershärte | 160-190 | 180-210 | min. 200 |
| Brinellhärte | 150-180 | 170-200 | min. 190 |

| Federbiegegrenze R_{FB} | | | |
|---|---|---|---|
| in N/mm² mind.350 | 160-190 | | |
| in N/mm² mind.370 | | 180-210 | |

Der Versteifungsring 8 und der Halbleiterkristall 7 sind mittels einer Klebeschicht 10 auf der flexiblen Trägerfolie 2 befestigt. Das Innere des Versteifungsringes (8) ist mit einer Abdeckmasse 11 ausgefüllt, so daß die Halbleiter-Kristalle 7 samt Bonddrähten 3 von der Abdeckmasse 11 schützend umgeben sind.

Fig. 2 zeigt das Trägerelement, 1 von Fig. 1 von oben. Der Versteifungsring 8 weist eine Dicke von ca. 0,4 mm auf und kann somit ohne weiteres in Chip-Karten mit einer Normdicke von 0,76 mm (ISO-Norm) integriert werden. Der Versteifungsring 8 ist in seiner Grundform kreisringförmig mit einem inneren Durchmesser von R1 = 4,5 mm und einem äußeren Durchmesser von R2 = 6,0 mm. Der Versteifungsring 8 weist auf seiner Außenseite zwei einander gegenüberliegende gerade Bereiche 12 und 13 auf. Die geraden Bereiche 12 und 13 ermöglichen bzw. erleichtern die Orientierung des Versteifungsrings 8 auf der Trägerfolie 2, da sie als Marken bzw. Markierungen für optische Erkennungsysteme von Handhabungsautomaten dienen. Der Außendurchmesser Da des Versteifungsringes 8 gemessen an diesen geraden Bereichen 12 und 13 beträgt ca. 10,4 mm, der Innendurchmesser Di des Versteifungsringes beträgt an diesen Stellen 8,4 mm. Auf der Innenseite des Versteifungsringes 8, den geraden Bereichen 12 und 13 gegenüberliegend, sind ebenfalls Marken für optische Erkennungssysteme in Form von rechteckförmigen Vorsprüngen 14 und 15 vorgesehen. Die Vorsprünge 14 und 15 dienen in erster Linie zur Orientierung von vollautomatischen Bond-Maschinen. Zusätzlich erhöhen die Vorsprünge 14 und 15 auch die Stabilität des in den geraden Bereichen 12 und 13 schmäleren Versteifungsrings 8. Das Außenmaß da ist durch die ISO-Norm vorgegeben. Die Tiefe T dieser Vorsprünge beträgt dabei ca. 0,5 mm und ihre Breite B ca. 1,4 mm. Die Form des Versteifungsringes 8 gemäß Fig. 2 weist zum einen eine genügend hohe Biegesteifigkeit auf und zum anderen ist diese Form für den Einsatz in Chip-Karten nach ISO-Norm optimiert. In dem Versteifungsring 8 gemäß Fig. 2 lassen sich Halbleiter-Chips bis zu einer Grundfläche bis zu 5,7 x 5,7 mm einsetzen. Das Vorsehen von Marken für optische Erkennungssysteme erlaubt eine rationelle Fertigung der Trägerelement mit hohen Stückzahlen.

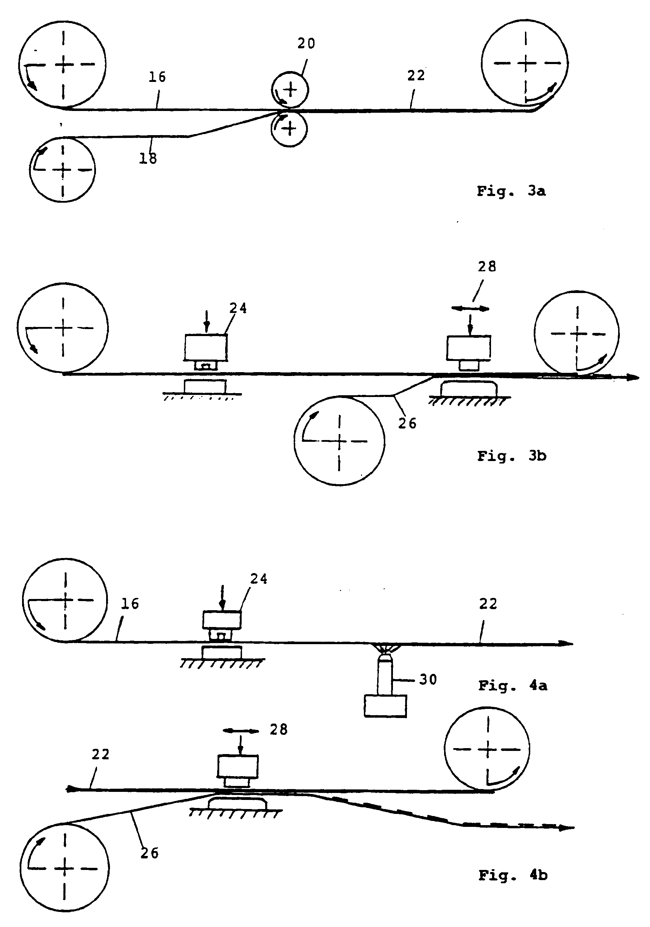

Das erfindungsgemäße Trägerelement 1 wird vorzugsweise in Bandform hergestellt, d. h. eine Mehrzahl von aufeinanderfolgenden Trägerelementen wird in Form eines Flachbandes bereitgestellt. Fig. 3 dient der Erläuterung einer ersten Variante eines Herstellungsverfahrens für die Trägerelemente nach Fig. 1. Das Material für den Versteifungsring 8 liegt in Form eines ersten Bandes 16 vor. Ein doppelseitiges Klebeband 18 zur Bildung der Klebeschicht 10 wird bereitgestellt. Eine Seite des Klebebandes 18 ist mit einer nicht dargestellten Schutzfolie überzogen. Beide Bänder liegen in Rollenform vor. Die beiden Bänder 16 und 18 werden abgerollt und einer Preßvorrichtung 20 zugeführt. Die Zusammenführung der beiden Bänder erfolgt dabei so, daß die Seite des Klebebandes 18, die keine Schutzfolie aufweist durch die Preßvorrichtung 20 mit dem ersten Band 16 verklebt wird. Das entstehende Kombi-Band 22 mit der Klebeschicht 10 kann entweder unmittelbar einer Ringstanze 24 zugeführt werden oder wieder aufgerollt und zu einem späteren Zeitpunkt weiter verarbeitet werden. Die Ringstanze 24 stanzt aus dem Kombi-Band 22 den Versteifungsring 8 in der gewünschten Form aus. Die Ringstanze 24 ist jedoch so ausgebildet, daß der Versteifungsring 8 in dem Kombi-Band 22 verbleibt, so daß das Kombi-Band 22 mit dem Versteifungsring 8 weiterverarbeitet werden kann. In einem nächsten Verfahrensschritt wird die in Form eines zweiten Bandes 26 vorliegende flexible Trägerfolie 2 mit dem Kombi-Band 22 zusammengeführt und die beiden Bänder 22 und 26 werden relativ zueinander in einer Positionier- und Preßvorrichtung 28 so positioniert, daß der Versteifungsring 8 in der gewünschten Lage über den Anschlußpunkten 6 zu liegen kommt. In einen weiteren Verfahrensschritt wird der Versteifungsring 8 aus dem Kombi-Band 22 herausgedrückt und in der gewünschten Position mit den zweiten Band 26 verklebt. Dazu muß vorher, vorzugsweise zwischen Ringstanze 24 und dem Zuführen des zweiten Bandes 26, die noch auf dem Kombi-Band 22 befindliche Schutzfolie entfernt werden (nicht dargestellt). Das verbleibende Kombi-Band 22 ohne Versteifungsring 8 kann aufgesammelt werden und die entstandenen Trägerelemente 1 mit Versteifungsring 8 in Form eines Endlosbandes können entweder ebenfalls aufgerollt werden oder unmittelbar der weiteren Verarbeitung, dem Bestücken mit dem Halbleiterkristall 7, zugeführt werden.

Fig. 4 zeigt eine zweite Variante eines Verfahrens zur Herstellung der Trägerelemente nach Fig. 1. In Fig. 4 sind entsprechende Komponenten mit den gleichen Bezugszeichen versehen wie in Fig. 3. Das in Fig. 4 schematisch dargestellte Verfahren unterscheidet sich von dem Verfahren gemäß Fig. 3 lediglich dadurch, daß die Klebeschicht 10 nicht in Form eines doppelseitigen Klebebandes auf das erste Band aufgebracht wird, sondern unmittelbar mittels einer Klebestoff-Sprühvorrichtung 30 auf das erste Band 16 aufgebracht wird. Da die Klebeschicht 10 dann ohne Schutzfilm vorliegt, wird die Klebeschicht 10 erst nach dem Ausstanzen des Versteifungsrings 8 in der Ringstanze 24 durchgeführt. Das mit der Klebeschicht 10 versehene Kombi-Band 22 wird dann unmittelbar der Preß- und Positioniervorrichtung 28 zugeführt, der ebenfalls die flexible Trägerfolie 2 in Form des zweiten Bandes 26 zugeführt wird. Die weiteren Verfahrensschritte entsprechen dem Verfahren nach Fig. 3.

Es sei betont, daß sämtliche Verfahrensschritte vollautomatisch ohne jegliche Handarbeit durchgeführt werden. Anstatt das Material für den Versteifungsring 8, die Trägerfolie, etc. in Bandform zuzuführen, kann es auch mittels bekannter Magazinanordnungen zugeführt werden.

Die nach dem Verfahren gemäß Fig. 3 bzw. 4 hergestellten Trägerelemente 1 in Form eines Flachbandes werden dann ebenfalls vollautomatisch mit einem oder mehreren Halbleiter-Kristalle 7 bestückt und das Innere des Versteifungsrings 8 mit dem Halbleiter-Kristall 7 und Anschlußdrähten 3 wird dann mit der Abdeckmasse 11 ausgegossen. Wenn die Abdeckmasse 11 ausgehärtet ist, wird, sofern nötig, überschüssige Abdeckmasse abgeschliffen. Das Bestücken der Trägerfolie bzw. Trägersubstrate 2 mit den Halbleiterkristallen 7 geschieht mittels bekannter Verfahren bzw. mit bekannten vollautomatischen Bestückungsvorrichtungen und Bond-Maschinen. Auch das Ausgießen des Inneren des Versteifungsrings 8 mit der Guß- bzw. Abdeckmasse 11 geschieht in bekannter Weise. Die so entstehenden mit einem oder mehreren Halbleiter-Schaltkreisen bestückten Trägerelemente 1 können dann separiert und beispielsweise in Chip-Karten eingebaut werden. In vorteilhafter Weise erfolgt das Trennen der einzelnen fertigbestückten Trägerelemente erst unmittelbar vor bzw. beim Einbau in die Chip-Karten.

Das vorstehend beschriebene Trägerelement ist insbesondere für den Einbau in Chip-Karten nach ISO-Norm geeignet und ausgelegt. Die erfindungsgemäßen Trägerelemente lassen sich natürlich auch in andere Schaltungen und Vorrichtung einbauen, die mechanischen Beanspruchungen ausgesetzt sind.

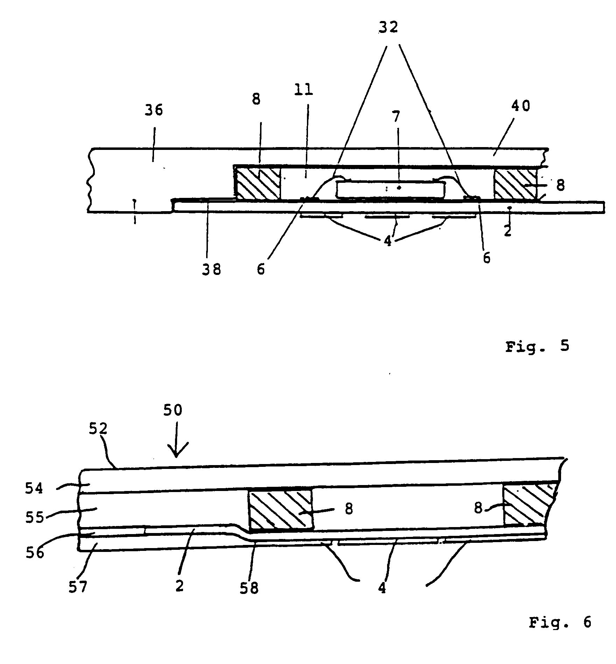

Fig. 5 zeigt eine Schnittansicht einer ersten Ausführungsform einer erfindungsgemäßen Chip-Karte 36. Die Chip-Karte 36 weist einen Kartenkörper 37 mit einem darin integrierten Trägerelement 1 auf auf dem der integrierte Schaltkreis 7 aufgeklebt ist. Das Trägerelement 1 mit Halbleiter-Chip 7 ist in eine entsprechende Aussparung 38 des Kartenkörpers 37 eingebettet. Die Oberseite des Versteifungsrings 8 wird von einer Abdeckschicht 40, die Teil des Kartenkörpers 37 ist, überzogen. Die Unterseite des Trägerelements 1 bzw. der Trägerfolie 2 fluchtet mit einer Seite der Chip-Karte 36, so daß die Kontaktflächen 4 von dieser Seite der Chip-Karte 36 zugänglich sind.

Fig. 6 zeigt schematisch eine bevorzugte weitere Ausführungsform einer Chip-Karte 50. Auch die Chip-Karte 50 weist einen Kartenkörper 52 auf, in den das erfindungsgemäße Trägerelement 1 mit IC integriert ist. Der Kartenkörper 52 besteht aus vier Laminatschichten, einer oberen Deckschicht 54, einer Mittelschicht 55, einer Ausgleichsschicht 56 und einer unteren Deckschicht 57, die bei der Herstellung der Chip-Karte 50 unter Heißdruck zum Kartenkörper 52 verpreßt werden. Die Mittelschicht 55. die Ausgleichsschicht 56 und die untere Deckschicht 57 weisen Ausnehmungen auf, die zusammen eine Aussparung 58 bilden, den das Trägerelement 1 ausfüllt. Die obere Deckschicht 54 überdeckt den Verstärkungsring 8. Dann folgt als nächste Laminatschicht die Mittelschicht 55, deren Dicke kleiner als die Höhe des Verstärkungsringes 8 ist und eine Ausnehmnung aufweist, die dem Querschnitt des Verstärkungsringes 8 entspricht. Dann folgt die Ausgleichsschicht 56, deren Dicke gleich der Dicke des Trägersubstrats 2 ist. Die Ausgleichsschicht 56 weist eine Ausnehmung auf, die der Fläche des Trägerelemnts 1 entspricht und die somit größer ist als die Ausnehmung in der Mittelschicht 55. Schließlich folgt noch die untere Deckschicht 57, die die andere Seite des Trägerelements 1 und damit das Trägersubstrat 2 abdeckt und nur die Kontaktflächen 4 frei zugänglich läßt. Damit wird nicht nur das ganze Trägerelement 1 sandwichartig durch Laminatschichten eingeschlossen, sondern ebenso der nicht von dem Verstärkungsring 8 überdeckte Teil des flexiblen Trägersubstrats 2.

Der Halt des Trägerelements 1 in dem Kartenkörper 52 wird zusätzlich noch dadurch verbessert, daß der nicht von dem Verstärkungsring 8 überdeckte Teil des Trägersubstrats 2 tiefer in dem fertigen Kartenkörper 52 angeordnet ist, als der von dem Verstärkungsring 8 überdeckte Teil des Trägersubstrats 2. Damit bildet der von den Versteifungsring 8 überdeckte Teil des Trägersubstrat 2 eine flache Mulde im nicht von dem Versteifungsring 8 überdeckten Teil des Trägersubstrats 2. Um die Anordnung nach Fig. 6 zu ermöglichen, muß eine besonders flexibles Trägersubstrat 2 verwendet werden. Besonders geeignet ist hierfür eine Folie aus Polyimid wegen ihrer Temperaturstabilität bis 250°C und ihrer hohen Flexibilität. Die Dicke der verwendeten Folien liegt bei ca. 100 um.

Der Zugriff auf den in der Chip-karte eingebetteten Halbleiterkristall kann anstelle über Kontaktflächen auch über Induktionsschleifen erfolgen. Dies hat den Vorteil, daß obere und untere Deckschichten keinerlei Ausnehmungen aufweisen müssen, d. h. das Trägerelement ist vollständig in den Kartenkörper eingebettet.

Es lassen sich auch mehrere Trägerelemente oder ein einzelnes Trägerelement mit mehreren nebeneinander angeordneten Versteifungsringen in eine Chip-Karte einbauen.

## Patentansprüche

1. Trägerelement mit mit wenigstens einem integrierten Schaltkreis (7) in Form eines Halbleiterkristalls insbesondere für den Einbau in Chip-Karten, mit
einem flexiblen Trägersubstrat (2), auf dessen Oberfläche mehrere Kontaktflächen (4) vorgesehen sind, die über Leiterbahnen mit Anschlußpunkten (6) für den wenigstens einen integrierten Schaltkreis (7) verbunden sind, und
einem Versteifungsring (8), der auf dem flexiblen Trägersubstrat befestigt ist, der eine innere Teilfläche des Trägersubstrats (2) umschließt und der auch außen von einer periphären Teilfläche des Trägersubstrats(2) umgeben ist, wobei der bzw. die integrierten Schaltkreise (7) auf der inneren Teilfläche angeordnet ist bzw. sind, dadurch gekennzeichnet,
daß zumindest die von dem Verstärkungsring (8) bedeckten und umschlossenen Bereiche des flexiblen Trägersubstrats (2) durchgehend ebene Flächen bilden,
daß der Versteifungsring (8) eine wesentlich höhere Biegesteifigkeit aufweist, als das flexible Trägersubstrat (2), so daß sich bei Verbiegung des flexiblen Trägersubstrats (2) der Versteifungsring (8) nicht verbiegt,
daß die Dicke des Versteifungsrings (8) kleiner ist als seine Breite, und
daß der Versteifungsring (8) im Verbund mit dem flexiblen Trägersubstrat (2) als verwindungssteife Zelle wirkt und dadurch den Halbleiterkristall (7) vor mechanischen Beanspruchungen schützt.

2. Trägerelement nach Anspruch 1, dadurch gekennzeichnet, daß die Breite des Versteifungsrings (8) in Richtung des Durchmessers ca. 1,5 mm und die Dicke des Versteifungsrings ca. 0,4 mm beträgt.

3. Trägerelement nach Anspruch 1 oder 2, dadurch gekennzeichnet, daß der Versteifungsring (8) kreisringförmig ist.

4. Trägerelement nach einem der vorhergehenden Ansprüche, dadurch gekennzeichnet, daß das Material, aus dem der Versteifungsring (8) besteht einen Elastizitätsmodul aufweist, das größer als 500 N/mm² ist.

5. Trägerelement nach einem der vorhergehenden Ansprüche, dadurch gekennzeichnet, daß der Versteifungsring (8) aus Metall bzw. einer Metall-Legierung besteht.

6. Trägerelement nach Anspruch 5, dadurch gekennzeichnet, daß der Versteifungsring (8) aus CuSn6, 195 HV oder CrNi 17/7, 220 HV besteht.

7. Trägerelement nach einem der vorhergehenden Ansprüche, dadurch gekennzeichnet, daß der Versteifungsring (8) mit dem flexiblen Trägersubstrat (2) verklebt ist.

8. Trägerelement nach einem der vorhergehenden Ansprüche, dadurch gekennzeichnet, daß der Versteifungsring (8) Marken (12, 14) für optische Erkennungssysteme aufweist.

9. Trägerelement nach Anspruch 8, dadurch gekennzeichnet, daß die Marken (12, 14) zapfenförmige Vorsprünge (14) umfassen, die in das Innere des Versteifungsrings (8) weisen.

10. Trägerelement nach Anspruch 8 oder 9, dadurch gekennzeichnet, daß die Marken (12, 14) gerade Bereiche (12) am äußeren Rand des Versteifungsringes (8) umfassen.

11. Trägerelement nach einem der vorhergehenden Ansprüche, dadurch gekennzeichnet, daß das flexible Trägersubstrat (2) aus Polyimid besteht.

12. Chip-Karte mit wenigstens einem integrierten Schaltkreis, der auf einem Trägerelement angeordnet ist, gekennzeichnet durch ein Trägerelement (1) nach einem der Ansprüche 1 bis 11.

13. Chip-Karte nach Anspruch 12, dadurch gekennzeichnet, daß es sich um eine Chip-Karte in ISO-Norm handelt.

14. Chip-Karte nach einem der Ansprüche 12 bis 13, dadurch gekennzeichnet, daß der Teil des Trägersubstrats (2), der von dem Versteifungsring (8) umfaßt und überdeckt ist, eine flache Mulde in dem übrigen Teil des Trägersubstrats (2) bildet, der nicht von dem Versteifungsring (8) umfaßt und überdeckt wird, so daß der übrige Teil des Trägersubstrats (2) tiefer im Chip-Kartenkörper angeordnet ist.

15. Verfahren zur Herstellung eines Trägerelements nach einem der Ansprüche 1 bis 11 mit den Verfahrensschritten:
a) Bereitstellen des Materials für den Versteifungsring (8) in Form eines ersten Bandes (16);
b) Bereitstellen des flexiblen Trägersubstrats (2) mit Leiterbahnen, Kontaktflächen (4) und Anschlußpunkten (6) für integrierte Schaltkreise in Form eines zweiten Bandes (26);
c) Versehen des ersten Bandes (16) mit einer Klebeschicht (10), so daß ein Kombi-Band (22) entsteht;
d) Ausstanzen des Versteifungsringes (8) aus dem Kombi-Band (22) derart, daß die Dicke des Versteifungsrings kleiner ist als seine Breite in Richtung des Durchmessers und der Versteifungsring (8) in dem Kombi-Band (22) verbleibt;
e) Zusammenführen des Kombi-Bandes (22) mit dem ausgestanzten Versteifungsring (8) und dem zweiten Band (26) und Positionieren der Versteifungsringe (8) in dem Kombi-Band (22) über den Anschlußpunkten (6) für integrierte Schaltkreise auf dem zweiten Band (26);
f) Trennen der Versteifungsringe (8) von dem Kombi-Band (22) und Verkleben der positionierten Versteifungsringe (8) mit dem zweiten Band (26).
g) Bestücken des zweiten Bandes (26) mit wenigstens einem integrierten Schaltkreis (7) und Herstellen der elektrischen Verbindungen zwischen den Anschlußpunkten (6) und dem integrierten Schaltkreis; und
h) Ausfüllen des Inneren des Versteifungsrings (8) mit einer Abdeckmasse (11).

16. Verfahren nach Anspruch 15, dadurch gekennzeichnet, daß die Verfahrensschritte c) und d) vertauscht sind.

17. Verfahren nach Anspruch 15 oder 16, dadurch gekennzeichnet, daß im Vefahrensschritt c) ein doppelseitiges Klebeband (18) mit dem ersten Band (16) verpreßt wird.

18. Verfahren nach Anspruch 15 oder 16, dadurch gekennzeichnet, daß im Verfahrensschritt c) die Klebeschicht (10) auf das erste Band aufgesprüht wird.

## Claims

1. A carrier element comprising at least one integrated circuit (7) in the form of a semiconductor crystal, more particularly for inclusion in chip cards, comprising
a flexible carrier substrate (2), on the surface of which there are provided a number of contact surfaces (4) connected via printed conductors to junction points (6) for the integrated circuit (7), and
a stiffening ring (8) being secured on the flexible carrier substrate (2), enclosing an inner partial surface of the carrier substrate (2) and being surrounded by a peripheral partial surface on its outer side, said integrated circuit (7) or integrated circuits being disposed on the inner partial surface,
**characterised in**
that at least the areas of the flexible carrier substrate (2) covered and surrounded by the stiffening ring (8) form a continuos plane surface,
that the stiffening ring (8) has a much greater resistance to bending than the flexible carrier substrate (2) so that if the flexible carrier substrate (2) is bent the stiffening ring (8) does not bend,
that the thickness of the stiffening ring (8) is smaller than its width, and
that the stiffening ring (8) acts as a torsion-resistant cell in conjunction with the flexible carrier substrate (2) and thus protects the semiconductor crystal (7) from mechanical stresses.

2. A carrier element according to claim 1, characterised in that the width of the stiffening ring (8) in direction of its diameter is about 1,5 mm and the thickness of the stiffening ring (8) is about 0,4 mm.

3. A carrier element according to claim 1 or 2, characterised in that the stiffening ring (8) is circular.

4. A carrier element according to any one of the preceding claims, characterised in that the material of which the stiffening ring (8) consists has a modulus of elasticity greater than 500 N/mm².

5. A carrier element according to any one of the preceding claims, characterised in that the stiffening ring (8) consists of metal or a metal alloy.

6. A carrier element according to claim 5, characterised in that the stiffening ring (8) consists of CuSn6, 195 HV or CrNi 17/7, 220 HV.

7. A carrier element according to any one of the preceding claims, characterised in that the stiffening ring (8) is adhered to the flexible carrier substrate (2).

8. A carrier element according to any of the preceding claims, characterised in that the stiffening ring (8) has markings (12, 14) for optical recognition systems.

9. A carrier element according to claim 8, characterised in that the markings (12, 14) comprise projections (14) in the form of pins pointing to the interior of the stiffening ring (8).

10. A carrier element according to claim 8 or 9, characterised in that the markings (12, 14) comprise straight zones (12) at the outer edge of the stiffening ring (8).

11. A carrier element according to any one of the preceding claims, characterised in that the flexible carrier substrate (2) consists of polyimide.

12. A chip card comprising at least one integrated circuit disposed on a carrier element, characterised by a carrier element (1) according to any one of claims 1 to 11.

13. A chip card according to claim 12, characterised in that it is an ISO-Standard chip card.

14. A chip card according to any one of claims 12 to 13, characterised in that that part of the carrier substrate (2) which is surrounded and covered by the stiffening ring (8) forms a shallow trough in the remaining part of the carrier substrate (2) which is not surrounded and covered by the stiffening ring (8) so that the remaining part of the carrier substrate (2) is disposed more deeply in the chip card.

15. A process for the production of a carrier element according to any one of claims 1 to 11 comprising the following steps:
a) preparing the material for the stiffening ring (8) in the form of a first strip (16);
b) preparing the flexible carrier substrate (2) with printed conductors, contact surfaces (4) and junction points (6) for integrated circuits in the form of a second strip (26);
c) providing the first strip (16) with an adhesive coating (10) so as to form a combination strip (22);
d) stamping the stiffening ring (8) out of the combination strip (22) in such manner that the thickness of the stiffening ring (8) is smaller than its width and that the stiffening ring (8) remains in the combination strip (22);
e) bringing together the combination strip (22) with the stamped-out stiffening ring (8) and the second strip (26) and positioning the stiffening rings (8) in the combination strip (22) above the junction points (6) for integrated circuits on the second strip (26);
f) separating the stiffening rings (8) from the combination strip (22) and sticking the positioned stiffening rings (8) to the second strip (26);
g) providing the second strip (26) with at least one integrated circuit (7) and making the electrical connections between the junction points (6) and the integrated circuit; and
h) filling the interior of the stiffening ring (8) with a masking compound (11).

16. A process according to claim 15, characterised in that the steps c) and d) are changed over.

17. A process according to claim 15 or 16, characterised in that in step c) a double-sided adhesive strip (18) is pressed to the first strip (16).

18. A process according to claim 15 or 16, characterised in that in step c) the adhesive coating (10) is sprayed on to the first strip.

## Revendications

1. Elément formant support avec au moins un circuit intégré (7) sous forme de cristal semi-conducteur, en particulier pour le montage de cartes a puce, avec
un substrat de support (2) flexible, sur la surface duquel plusieurs surfaces de contact (4) sont prévues, lesquelles sont reliées par l'intermédiaire de pistes conductrices à des points de raccordement (6) pour le circuit intégré (7) au moins un de nombre, et
un anneau de renforcement (8) qui est fixé sur le substrat de support flexible, qui entoure une partie intérieure de la surface du substrat de support (2) et qui est, de son tour, entouré à l'extérieur par une partie périphérique de substrat de support (2), le ou les circuit(s) intégré(s) (7) étant disposé(s) sur la partie intérieure de la surface,
caractérisé en ce que
du moins les régions du substrat de support (2) flexible, qui sont couvertes et entourées par l'anneau de renforcement (8), forment des surfaces plates en continu,
l'anneau de renforcement (8) présente une rigidité flexionnelle essentiellement plus élevée que le substrat de support (2) flexible, de sorte que l'anneau de renforcement (8) ne se déforme pas lors de la flexion du substrat de support (2) flexible,
l'épaisseur de l'anneau de renforcement (8) est inférieure à sa largeur, et
l'anneau de renforcement (8), en liaison avec le substrat de support (2) flexible, agit comme cellule de raidissement de torsion et protège, par conséquent, le cristal semiconducteur (7) des contraintes méchaniques.

2. Elément formant support selon la revendication 1, caractérisé en ce que la largeur de l'anneau de renforcement (8) est d'environ 1,5 mm dans la direction de diamètre, et l'épaisseur de l'anneau de renforcement (8) est d'environ 0,4 mm.

3. Elément formant support selon la revendication 1 ou 2, caractérisé en ce que l'anneau de renforcement (8) est en forme de couronne circulaire.

4. Elément formant support selon une des revendications précédentes, caractérisé en ce que le matériau dont l'anneau de renforcement (8) est constitué, présente un module d'élasticité qui est supérieur à 500 N/mm².

5. Elément formant support selon une des revendications précédentes, caractérisé en ce que l'anneau de renforcement (8) est constitué d'un métal, respectivement d'un alliage métallique.

6. Elément formant support selon la revendication 5, caractérisé en ce que l'anneau de renforcement (8) se compose de CuSn6 à HR 195 ou de CrNi 17/7 à HR 220.

7. Elément formant support selon une des revendications précédentes, caractérisé en ce que l'anneau de renforcement (8) est collé au substrat de support (2) flexible.

8. Elément formant support selon une des revendications précédentes, caractérisé en ce que l'anneau de renforcement (8) présente des repères (12, 14) pour des systèmes de reconnaissance optiques.

9. Elément formant support selon la revendication 8, caractérisé en ce que les repères (12, 14) comprennent des saillies (14) en forme de tenon qui indiquent l'intérieur de l'anneau de renforcement (8).

10. Elément formant support selon la revendication 8 ou 9, caractérisé en ce que les repères (12, 14) comprennent des zones rectilignes (12) sur le bord extérieur de l'anneau de renforcement (8).

11. Elément formant support selon une des revendications précédentes, caractérisé en ce que le substrat de support (2) flexible est constitué de polyimide.

12. Carte à puce avec au moins un circuit intégré qui est disposé sur un élément formant support, caractérisée par un élément formant support (1) selon les revendications 1 à 11.

13. Carte à puce selon la revendication 12, caractérisée par le fait qu'il s'agit d'une carte à puce de la norme ISO.

14. Carte à puce selon la revendication 12 ou 13, caractérisée en ce que la partie du substrat de support (2), qui est entourée et couverte par l'anneau de renforcement (8), forme un évidement plat dans la partie restante du substrat de support (2) qui est ni entourée ni couverte par l'anneau de renforcement (8), de sorte que la partie restante du substrat de support (2) est placée plus bas dans le corps de la carte à puce.

15. Procédé de fabrication d'un élément formant support selon une des revendications 1 à 11, avec les opérations de base:
a) Préparer le matériau pour l'anneau de renforcement (8) sous forme d'une première bande (16);
b) Préparer le substrat de support (2) flexible avec pistes conductrices, surfaces de contact (4) et points de raccordement (6) pour circuits intégrés, sous forme d'une deuxième bande (26);
c) Munir la première bande (16) d'une couche adhésive (10), de façon à former une bande combinée (22);
d) Estamper l'anneau de renforcement (8) à partir de la bande combinée (22), de sorte que l'épaisseur de l'anneau de renforcement est inférieure à sa largeur dans la direction de diamètre, et l'anneau de renforcement (8) reste dans la bande combinée (22);
e) Réunir la bande combinée (22) avec l'anneau de renforcement (8) estampé et avec la deuxième bande (26) et positionner les anneaux de renforcement (8) de la bande combinée (22) par l'intermédiaire des points de raccordement (6) pour circuits intégrés, sur la deuxième bande (26);
f) Séparer les anneaux de renforcement (8) de la bande combinée (22) et coller les anneaux de renforcement (8) positionnés sur la deuxième bande (26);
g) Equiper la deuxième bande (26) avec au moins un circuit intégré (7) et fabriquer les liaisons électriques entre les points de raccordement (6) et le circuit intégré; et
h) Remplir l'intérieur de l'anneau de renforcement (8) avec une masse de recouvrement (11).

16. Procédé selon la revendication 15, caractérisé en ce que les opérations de base c) et d) sont permutées.

17. Procédé selon la revendication 15 ou 16, caractérisé en ce que dans l'opération de base c), une bande adhésive (18) à double face est comprimée avec la première bande (16).

18. Procédé selon la revendication 15 ou 16, caractérisé en ce que dans l'opération de base c), la couche adhésive (10) est dispersée sur la première bande.
